Europäisches Patentamt

European Patent Office

Office européen des brevets

(19)

(11) Veröffentlichungsnummer: **0 254 056 B1**

# (12) EUROPÄISCHE PATENTSCHRIFT

(45) Veröffentlichungstag der Patentschrift: **22.05.91**

(51) Int. Cl.⁵: **C25D 17/06**

(21) Anmeldenummer: **87109026.2**

(22) Anmeldetag: **23.06.87**

(54) **Langgestreckte Gestelle mit Haltebügeln zum lösbaren Befestigen von Leiterplatten.**

(30) Priorität: **22.07.86 DE 3624759**

(43) Veröffentlichungstag der Anmeldung:
**27.01.88 Patentblatt 88/04**

(45) Bekanntmachung des Hinweises auf die
Patenterteilung:
**22.05.91 Patentblatt 91/21**

(84) Benannte Vertragsstaaten:
**BE CH DE ES FR GB IT LI LU NL SE**

(56) Entgegenhaltungen:
**DE-U- 8 600 962**
**US-A- 3 013 959**

(73) Patentinhaber: **SCHERING AKTIENGESELL-
SCHAFT Berlin und Bergkamen
Müllerstrasse 170/178 Postfach 65 03 11
W-1000 Berlin 65(DE)**

(72) Erfinder: **Kuhn, Peter
Benediktinerstrasse 47
W-1000 Berlin 28(DE)**

## Beschreibung

Die Erfindung betrifft langgestreckte Gestelle gemäß dem Oberbegriff des Anspruches 1. Solche Gestelle mit Haltebügeln zum klemmenden Erfassen der Ränder der Leiterplatten sind in der älteren Patentanmeldung P 36 06 492.0-45 der Anmelderin vorgesehen, und zwar dort in federnder Form, während die vorliegende Erfindung sich auf die federnde Ausbildung der Haltebügel zwar bevorzugt bezieht, jedoch auch Haltebügel aus einem nicht federnden Material mit einbezieht. Im übrigen wird hinsichtlich der Ausgestaltungsmöglichkeiten eine Anordnung nach dem Oberbegriff des Anspruches 1 und die hierdurch erzielten Vorteile der Offenbarungsinhalt der älteren Anmeldung P 36 06 492.0-45 mit zum Offenbarungsinhalt der vorliegenden Anmeldung gemacht.

Ausgehend von einer Anordnung gemäß dem Oberbegriff des Anspruches 1 besteht die Aufgabe der Erfindung darin, mit einfachen Mitteln ein ungewolltes Verschieben der Leiterplatten entgegen ihrer Einschubrichtung, sowie ein versehentliches Herausziehen der Ränder der Leiterplatten aus den Haltebügeln zu verhindern.

Die Lösung dieser Aufgabe wird zunächst, ausgehend vom Oberbegriff des Anspruches 1, in den Merkmalen des Kennzeichens des Anspruches 1 gesehen. Hiermit ist das Einschieben der Leiterplatten in die Haltebügel problemlos und leicht möglich und damit insbesondere für das Einschieben durch Automaten geeignet, da hierbei die Sperrglieder außer Funktion sind. Andererseits sind jedoch die Platten durch die Sperrglieder an einem versehentlichen Herausziehen, sowie an einer Verlagerung entgegen der vorgenannten Einschubrichtung gehindert. Ein solches versehentliches Herausziehen oder ungewolltes Verlagern kann nicht nur durch falsche Handhabung, sondern insbesondere auch durch das Eigengewicht der Platte geschehen, wenn aus irgendwelchen Gründen die Klemmkraft der Haltebügel nicht oder nur teilweise für den Halt der Platte ausreicht.

Eine weitere Erhöhung der Sperrwirkung oder Sperrkraft ergibt sich durch die Merkmale des Anspruches 2, da die Sperrglieder bzw. Hülsen beim Passieren der Abbiegung sich zusätzlich gegeneinander bewegen und damit die Plattenränder mit einer zusätzlichen Kraft klemmend ergreifen. An dieser Stelle sei bemerkt, daß die Herstellung der Haltebügel aus federnden Material, bevorzugt aus einem Stahldraht entsprechender Elastizität, einerseits eine genügende Haltekraft für die Plattenränder und andererseits eine sich auch Fertigungstoleranzen, sei es der Haltebügel oder sei es der Plattenränder, anpassende Sperrung gemäß der Erfindung ergibt.

Bei recht dünnen und recht langen Leiterplatten kann es geschehen, daß diese im Elektrolysebad durch den Druck der Badflüssigkeit aus den Haltegliedern herausrutschen. Die Aufgabe der Erfindung wird daher für diesen Fall darin gesehen, ein solches Herausrutschen zu verhindern. Zur Lösung dieser Aufgabe dienen die Merkmale des Anspruches 10, bevorzugt in der Ausführungsform gemäß Anspruch 11.

Erwähnt sei, daß man zum Stand der Technik gemäß DE-OS 33 42 712 Haltevorrichtungen in Form eines sogenannten Käfigs kennt, wobei die Leiterplatte in einen Schlitz des Käfigs eingeschoben wird und zwischen Rollen einer Seitenwand und einer Kugel sich bewegt, die auf einer zur erstgenannten Seitenwand gegenüberliegenden und dazu schräg verlaufenden Seitenwand rollt. Je nach Einschiebrichtung gibt die Kugel den Plattenrand frei oder klemmt ihn ein. Diese Anordnung unterscheidet sich sowohl vom Oberbegriff als auch vom Kennzeichen des Anspruches 1. Sie ist demgegenüber auch in mehrfacher Hinsicht nachteilig. Der nicht mehr galvanisierbare Rand der Leiterplatte wird beim Halt in der vorbekannten Anordnung sehr breit, da die Schlitzhalterung einen breiten Randbereich gegen den Elektrolysestrom abschirmt. Dies ist gemäß Oberbegriff des Anspruches 1 bei der Erfindung nicht der Fall. Nach dem Eintauchen in ein Elektrolyse-Bad muß die anhängende Elektrolytflüssigkeit weggespült werden. Dies ist beim Gegenstand der Erfindung ebenfalls problemlos möglich, da die Haltebügel dort frei für eine solche Spülung zugänglich sind. Dagegen bildet die vorbekannte Anordnung sogenannte Nester oder Sacklöcher, in denen trotz intensiver Spülung Reste der Elektrolytflüssigkeit hängen bleiben können. An diesen Stellen schlägt sich aber das aufzubringende Metall (Kupfer) nieder. Dies verringert dann den Abstand der beiden Wände im Schlitz und muß daher auf chemischen oder elektrolytischem Wege wieder entfernt werden. Dies ist äußerst mühsam und aufwendig, wobei außerdem während dieser Zeit die Gestelle nicht für den Galvanisierbetrieb zur Verfügung stehen. Zwar schlägt sich auch beim Gegenstand der Erfindung Kupfer an den Federn und Hülsen nieder. Da aber die Federn und auch die Hülsen frei vorragen, kann das Kupfer wesentlich leichter entfernt werden (chemisch oder elektrolytisch) als es beim Stand der Technik möglich ist. Schließlich ist die vorbekannte Anordnung in der Herstellung relativ kompliziert und damit auch in dieser Hinsicht aufwendig.

Weitere Vorteile und Merkmale der Erfindung sind den weiteren Unteransprüchen, sowie der nachstehenden Beschreibung und der dazugehörigen Zeichnung von erfindungsgemäßen Ausführungsbeispielen zu entnehmen. In der Zeichnung zeigt:

Fig. 1: In einem gegenüber den anderen Figuren verkleinerten Maßstab in der Frontansicht und schematisch zwei Gestelle mit Haltebügeln und Leiterplatte,

Fig. 2: einen Teilbereich A aus Fig. 1,

Fig. 3: eine Ansicht auf Fig. 2 gemäß dem Pfeil B in Freigabestellung der Sperrglieder,

Fig. 4: eine Ansicht auf Fig. 2 gemäß dem Pfeil B in Sperrstellung der Sperrglieder,

Fig. 5: einen Schnitt gemäß der Linie V - V in Fig. 4,

Fig. 6: in einer Ansicht analog Fig. 2 eine weitere Ausführungsmöglichkeit der Erfindung,

Fig. 7: einen Schnitt gemäß der Linie VII - VII in Fig. 6.

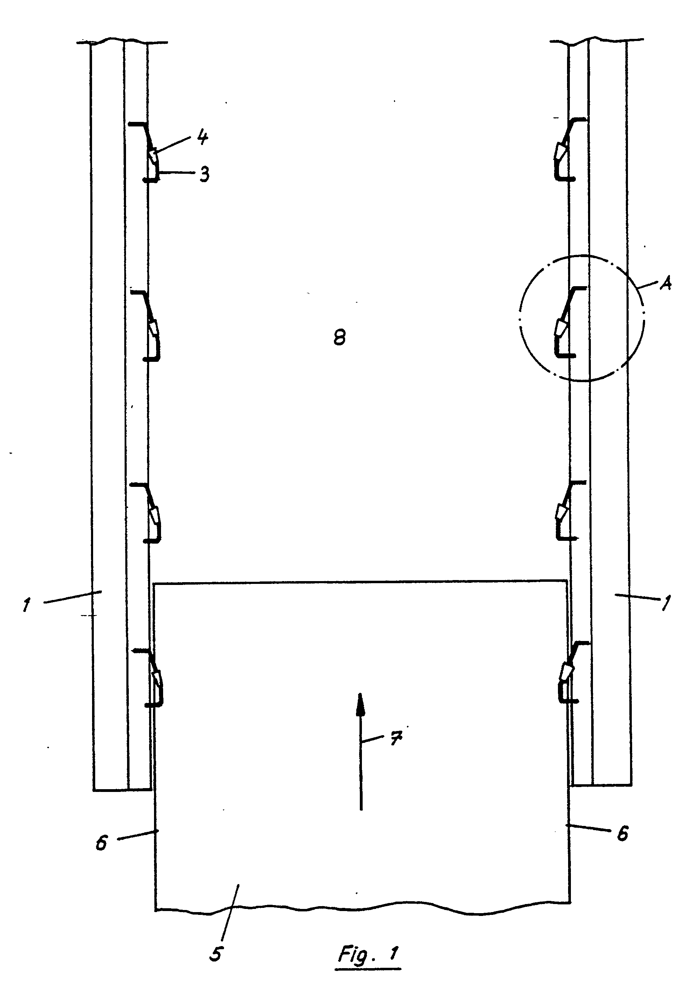

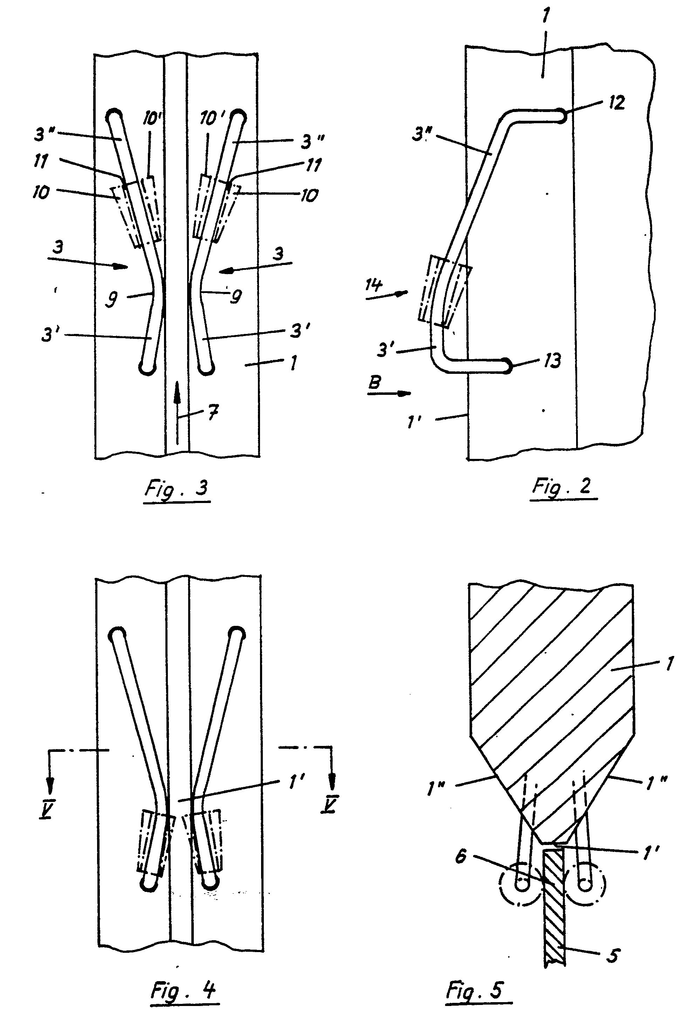

Fig. 1 zeigt zwei langgestreckte Gestelle 1, deren Form näher aus den Fig. 2 - 7 hervorgeht. An ihnen befinden sich Haltebügel 3 mit Sperrgliedern 4. Eine Leiterplatte 5 mit von den Haltebügeln 3 seitlich zu erfassenden Plattenrändern 6 wird in Pfeilrichtung 7 gemäß diesem Ausführungsbeispiel von unten zwischen die Haltebügel eingeschoben. Bevorzugt besteht jede Haltebügelanordnung aus einem Paar sich ergänzender Bügel 3. Es könnte aber auch jeweils nur ein Bügel vorgesehen sein, der mit einem Gegenlager zusammenarbeitet.

Es ist ersichtlich, daß die auch der Stromzuführung dienenden Haltebügel, bevorzugt, sind dies federnde Stahldrähte, von jedem Gestell 1 frei her nach innen in den Raum 8 zwischen den Gestellen vorragen.

Die Fig. 2 - 5 zeigen, daß sich die Plattenränder 6 in der Einschubrichtung 7 zwischen die sich trichterförmig nach unten erweiternden Bereiche 3' der Bügel 3 einschieben lassen. Von einer Abbiegung 9 der Bügel her laufen dann die Haltebügel in ihren Bereichen 3" wieder auseinander, d.h. bilden einen sich gemäß Fig. 3 nach oben erweiternden Trichter. Um die zeichnerische Darstellung nicht zu sehr zu belasten, ist die Leiterplatte in den Fig. 2 - 4 nicht gezeichnet, sondern nur in Fig. 5 angedeutet.

Jeder der Haltebügel 3 ist mit einem Sperrglied 10 in Form einer Hülse versehen, das den jeweiligen Bügel mit einer Bohrung 11 umgibt, die gegenüber den Haltebügeln ein gewisses Spiel hat, so daß die Hülse 10 in Längsrichtung der Haltebügel verschiebbar ist. Sie ist im übrigen in den Fig. 2 - 4 zur zeichnerischen Abhebung von den Haltebügeln strichpunktiert dargestellt.

In Fig. 3 sind durch das Einschieben der hier nicht gezeichneten Leiterplatte die Hülsen 10 nach oben verschoben und entsprechend weit voneinander distanziert, so daß die Leiterplatte 5 mit ihrem Rand 6 ohne ins Gewicht fallenden Widerstand in Richtung des Pfeiles 7 verschiebbar ist. Sobald aber auf die Leiterplatte ein Druck entgegen der Pfeilrichtung 7 ausgeübt wird, z.B. durch ihr Eigengewicht, versucht sie sich in der Darstellung der Fig. 2 - 4 nach unten zu bewegen, wodurch die Hülsen 10 auch nach unten bewegt und durch den erläuterten trichterförmigen Verlauf der Bereiche 3" zueinander hinbewegt werden, bis sie an den Plattenrändern 6 mit Klemmwirkung anliegen. Stattdessen oder zusätzlich dazu kann eine Klemmwirkung auch damit erreicht werden, daß die bereits erläuterte bogenförmige Abbiegung 9 im Verlauf der Haltebügel 3 vorgesehen ist, wobei die Innenbohrungen oder -öffnungen der Hülsen 10 so breit sind, daß die Hülsen über die jeweilige Abbiegung 9 hinweg in den Bereich 3' der Haltebügel gleiten können (Fig. 4). Damit verändert sich die Lage der Längsachse der Hülsen 10 so, daß ihre in der Zeichnung oberen Kanten 10' nach innen verlagert werden und sich von beiden Seiten her mit einer zusätzlichen Klemmkraft an den Leiterplattenrand 6 anlegen. Dieser Effekt kann noch dadurch verstärkt werden, daß die Hülsen 10 sich in der Einschubrichtung 7 erweitern, z.B. durch eine entsprechende Konizität und/oder auch durch im Bereich der oberen Kante 11 nach außen vorstehende Ränder. Hierdurch wird in der Lage gemäß Fig. 4 die Leiterplatte an ihren Rändern 6 wie durch eine Zange erfaßt.

Die Figuren, insbesondere Fig. 2 zeigen, daß in der Seitenansicht des Gestelles gemäß Fig. 2 nur ein kleinerer Teil der Haltebügel über die kurzen Seitenflächen 1' nach innen in den Raum 8 vorragt. Der übrige Teil des Haltebügels befindet sich seitlich neben dem Gestell 1, wodurch die Haltebügel nur einen sehr geringen Abschirmeffekt auf den elektrischen Strom im Bad haben, d.h. die Plattenränder nahezu vollständig galvanisiert werden. Die entsprechenden Befestigungs- oder Einstecklöcher der Gestelle 1 sind mit 12, 13 beziffert und an den langen Seitenflächen 1" gelegen (siehe Fig. 5). Von hier aus erstrecken sich die Haltebügel über einen wesentlichen Bereich ihrer Länge entlang des Gestelles, bis sie schließlich in den eigentlichen Halte- oder Klemmbereich 14 oberhalb der kurzen Seitenflächen 1' kommen, der auch die Hülse 10 aufweist. Damit möglichst wenig an Strom abgefangen wird, empfiehlt sich eine langgestreckte Querschnittsform der Gestelle 1, wie sie insbesondere aus Fig. 5 ersichtlich ist.

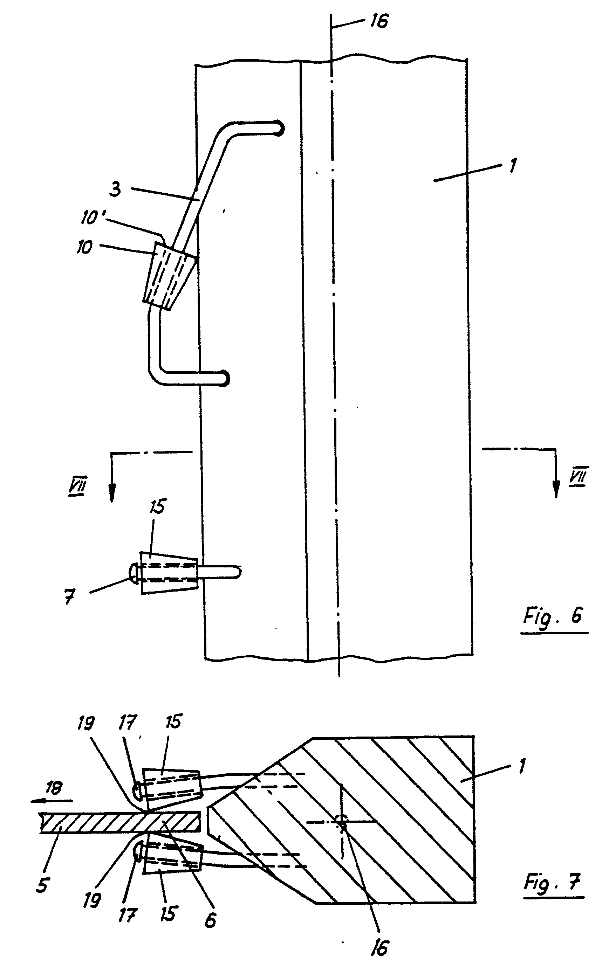

Die Fig. 6, 7 zeigen wieder das Gestell 1 mit Haltebügel 3 und Sperrglied 10. Außerdem sind weitere Sperrglieder 15 vorgesehen, die sich vom Gestell 1 her quer zu dessen Längsachse 16 nach innen in den Raum 8 hinein erstrecken und z.B. mittels Bolzen 17 gehalten, gegenüber denen sie sich sowohl um den Bolzenschaft 17 drehen als auch in Längsrichtung des Bolzens verschieben können. Bei einem Einschieben der Leiterplatte 5 in Richtung des Pfeiles 7 werden diese weiteren Sperrmittel 15, hier ebenfalls in Form entsprechend ausgebildeter Hülsen, lediglich um die Bolzenschäfte 17 gedreht und leisten daher diesem Einschieben keinen nennenswerten Widerstand. Sollte aber, wie eingangs erläutert, durch Druck der Badflüssigkeit oder sonstige Kräfte ein entsprechender Druck auf die Leiterplatte ausgeübt werden, so hat dies einen Zug auf die Leiterplattenenden in Richtung des Pfeiles 18 zur Folge. In diesem Fall verschieben sich die Hülsen 15 in dieser Richtung.Dies kann soweit erfolgen, bis sie an die Köpfe der Bolzen 17 anschlagen. Da die Bolzen zumindest in ihrem in Pfeilrichtung 18 gelegenen Bereich zueinander konvergieren, hat eine solche Bewegung der Hülsen 15 in Pfeilrichtung 18 zur Folge, daß sich die Kanten 19 der Hülsen einander nähern und in Art von Sperrhaken ein Herausziehen der Leiterplatten in Richtung des Pfeiles 18 verhindern.

**Ansprüche**

1. Langgestreckte Gestelle zum lösbaren Befestigen von Leiterplatten für die nachfolgende Galvanisierung, mit Haltebügeln um die Leiterplatten an ihren beiden einander gegenüberliegenden Längsseitenrändern zu halten, wobei die bevorzugt federnden Haltebügel auch der Stromzuführung dienen und von jedem Gestell her frei wegragen und zwar bevorzugt in den Raum zwischen diesen beiden Gestellen hinein, wobei die Haltebügel so ausgebildet sind, daß ein Einschieben bzw. Wiederherausziehen der jeweiligen Seitenränder der Leiterplatten in Gestell-Längsrichtung in die bzw. aus den Haltebügeln möglich ist und wobei jedes Gestell eine Anzahl von in Gestell-Längsrichtung übereinander und im Abstand voneinander angeordneten Haltebügeln aufweist, dadurch gekennzeichnet, daß die Haltebügel (3) mit einem in ihrer Längsrichtung verschiebbaren Sperrglied (4) versehen sind und daß eine Anordnung sowie Bemessung der Haltebügel und Sperrglieder derart gewählt ist, daß ein Verschieben des Sperrgliedes bzw. der Sperrglieder (4) in der Einschubrichtung (7) der Leiterplatte (5) das Sperrglied, bzw. die Sperrglieder vom Plattenrand (6) entfernt, dagegen ein Verschieben des Sperrgliedes bzw. der Sperrglieder (41 entgegen der Einschubrichtung (7) der Leiterplatte (5) das Sperrglied, bzw. die Sperrglieder zum jeweiligen Plattenrand (6) hin verlagert, und daß die Sperrglieder als die Haltebügel mit etwas Spiel umgebende Hülsen (4) ausgebildet sind.

2. Gestell nach Anspruch 1, dadurch gekennzeichnet, daß je ein Paar Haltebügel miteinander einen in der Einschubrichtung (7) sich erweiternden Trichter bildet.

3. Gestell nach einem der Ansprüche 1 oder 2, dadurch gekennzeichnet, daß die Haltebügel (3) in sich abgebogen sind und daß das Spiel zwischen den Sperrgliedern (4) und den Haltebügeln zumindest so groß ist, daß das jeweilige Sperrglied (4) bei seiner Verschiebung in Bügellängsrichtung über diese Abbiegung (9) hinweggleiten kann.

4. Gestell nach einem der Ansprüche 1 - 3, dadurch gekennzeichnet, daß die Sperrglieder (4) sich in ihrer Einschubrichtung in ihrem Außendurchmesser vergrößern.

5. Gestell nach Anspruch 4 , gekennzeichnet durch sich konisch vergrößernde Sperrglieder.

6. Gestell nach Anspruch 4 oder 5, dadurch gekennzeichnet, daß die in Einschubrichtung gelegenen Enden dar Sperrglieder einen scharfkantigen Rand (10') aufweisen.

7. Gestell nach einem der Ansprüche 2 - 6 dadurch gekennzeichnet, daß der sich in Einschubrichtung (7) erweiternde trichterförmige Bereich (3") der Haltebügel (3) an den Abbiegungen (9) am schmalsten ist und daß sich die Haltebügel von diesen Abbiegungen her entgegen der Einschubrichtung ebenfalls trichterförmig erweitern (3').

8. Gestell nach einem der Ansprüche 1 - 7, dadurch gekennzeichnet, daß die Gestelle (1) einen langgestreckten Querschnitt aufweisen und daß die Haltebügel (3) mit ihren Enden in Löchern (12, 13) der langen Seitenflächen (1") des Gestelles verankert sind und nur mit ihrem mittleren Klemm- und Haltebereich (14) soweit in den Bereich (8) zwischen den Gestellen vorragen, daß sie damit die an den kurzen Seitenflächen (1') der Gestelle anstoßenden Plattenränder (6) erfassen können.

9. Gestell nach Anspruch 8, dadurch gekennzeichnet, daß sich die Abbiegungen (9) im Klemm- bzw. Haltebereich (14) befinden.

10. Gestell nach einem der Ansprüche 1 - 9, dadurch gekennzeichnet, daß an den Gestellen (1) quer zu ihrer Längsrichtung (16) vorstehende Halter (17) mit weiteren Sperrteilen (15) angebracht sind, welche an den Plattenrändern (6) anliegen und diese gegen ein Verschieben nach innen (18), d.h. in den Raum (8) zwischen zwei zusammengehörenden Gestellen (1) sperren.

11. Gestell nach Anspruch 10, dadurch gekennzeichnet, daß die weiteren Sperrteile in Form konischer Hülsen (15) ausgebildet sind, die auf Bolzen (17) drehbeweglich und verschiebbar angeordnet sind, wobei die Bolzen (17) in Richtung nach innen (18) hin konvergieren.

**Claims**

1. Long racks for detachable affixing of circuit boards for subsequent electroplating with holding brackets designed to hold the circuitboards on their two opposite longitudinal sides, where the preferably spring-loaded holding brackets also serve for supplying power to the boards and project freely away from each rack preferably into the space between the two racks the holding brackets being designed in such a way that the particular side edges of the circuit board can in each case be inserted in or retracted from the holding brackets in the lengthwise direction of the rack and each rack having a number of holding brackets arranged in the longitudinal direction of the rack one above the other and at a distance from each other, characterized in that the holding brackets (3) are provided with a blocking device (4) shiftable in the longitudinal direction and that the holding brackets and blocking devices are arranged and dimensioned in such a way that by shifting the blocking device or blocking devices (4) in the direction of insertion (7) of the circuit board (5) the blocking device or blocking devices are removed from the edge (6) of the board whereas by shifting the blocking device or blocking devices (4) in a direction opposing the direction of insertion (7) of the circuit board (5) the blocking device or the blocking devices are moved towards the particular edge (6) of the board, and further characterized in that the blocking devices are designed as sleeves (4) surrounding the holding bracket with a certain amount of play.

2. Rack in accordance with Claim 1, characterized in that in each case one pair of holding brackets together form a funnel increasing in width in the direction of insertion (7).

3. Rack in accordance with Claims 1 or 2, characterized in that the holding brackets (3) are bent and that the play between the blocking devices (4) and the holding brackets is at least large enough to ensure that the particular blocking device (4) on being shifted in the longitudinal direction of the bracket can slide over this bend (9).

4. Rack in accordance with Claims 1 - 3, characterized in that the external diameter of the blocking devices (4) increases in the direction of insertion.

5. Rack in accordance with Claim 4, characterized in that the blocking devices are conical in shape.

6. Rack in accordance with Claim 4 or 5, characterized in that the ends of the blocking devices located in the direction of insertion have sharp edges (10').

7. Rack in accordance with Claims 2 - 6, characterized in that the section (3") of the holding brackets (3) which opens up in a funnel-like way in the direction of insertion (7) is narrowest at the bends (9) and that the holding brackets open up likewise in a funnel-shaped way (3') from these bends against the direction of insertion.

8. Rack in accordance with Claims 1 - 7, characterized in that the racks (1) have a stretched cross-section and that the holding brackets (3) are anchored with their ends in holes (12, 13) in the long side areas (1") of the rack and only project with their central clamping and holding area (14) far enough into the area (8) between the racks to ensure that they can grip the board edges (6) pressing against the short side areas (1') of the rack.

9. Rack in accordance with Claim 8, characterized in that the bent sections (9) are located in the clamping and/or holding area (14).

10. Rack in accordance with Claims 1 - 9, characterized in that projecting holders (17) with further blocking components (15) are arranged on the racks (1) transverse to their longitudinal direction (16), these pressing against the board edges (6) thus preventing them from being shifted inward (18) i.e. towards the space (8) between two related racks (1).

11. Rack in accordance with Claim 10, characterized in that the other blocking components are designed as conical sleeves (15) which are arranged so that they can be rotated and moved on bolts (17) with the bolts (17) converging in the inward direction (18).

**Revendications**

1. Bâti long servant à la fixation provisoire de plaquettes à circuits imprimés pendant le processus de galvanoplastie suivant, comportant des étriers de retenue destinés à saisir les plaquettes au bord de leurs grands côtés situés l'un en face de l'autre, il étant prévu premièrement que les étriers, de préférence élastiques, servent également à l'alimentation en électricité, qu'ils font librement saillie de chaque bâti, et ceci de préférence jusque dans l'espace situé entre deux bâtis, deuxièment que la forme des étriers de retenue permet un enfichage et un retirage des bords respectifs des plaquettes dans le sens longitudinal des bâtis vers et depuis les étriers de retenue, et troisièment que chaque bâti présente un nombre d'étriers de retenue dont l'agencement leur permet d'être superposés dans le sens longitudinal des bâtis et espacés l'un de l'autre, l'ensemble étant caractérisé par le fait que les étriers de retenue (3) sont pourvus d'un élément d'arrêt (4) déplaçable dans le sens de la longueur et que l'agencement et les dimensions des étriers de retenue et des arrêts permettent d'ôter l'arrêt voire les arrêts (4) du bord (6) de la plaquette en déplaçant les arrêts dans le sens de l'enfichage (7) de la plaquette (5) et, à l'inverse, d'amener l'arrêt voire les arrêts vers le bord respectif (6) de la plaquette en déplaçant l'arrêt voire les arrêts (4) dans le sens opposé au sens d'enfichage (7) de la plaquette (5) , et par le fait que les arrêts sont représentés par douilles (4) qui glissent avec un peu de jeu sur les étriers de retenue.

2. Bâti selon la revendication 1, caractérisé par le fait que chaque paire d'étriers de retenue forme un entonnoir s'ouvrant dans le sens de l'enfichage (7).

3. Bâti selon les revendications 1 ou 2, caractérisé par le fait que les étriers de retenue (3) sont courbés et que le jeu entre les éléments d'arrêt (4) et les étriers de retenue permet à l'arrêt respectif (4) lors de son déplacement dans le sens de la longueur de l'étrier de glisser sur cette courbure (9) de l'étrier.

4. Bâti selon les revendications 1 à 3, caractérisé par le fait que le diamètre des éléments d'arrêt (4) augmente dans le sens de l'enfichage.

5. Bâti selon la revendication 4, caractérisé par le fait que les arrêts s'élargissent en forme conique.

6. Bâti selon les revendications 4 ou 5, caractérisé par le fait que les extrémités des arrêts, orientées en sens de l'enfichage, présentent des bords à angles vifs (10').

7. Bâti selon l'une des revendications 2 à 6, caractérisé par le fait que la zone (3") des étriers de retenue (3), s'élargissant en forme d'entonnoir dans le sens de l'enfichage (7), est le plus étroite au niveau des courbures (9) et que les étriers de retenue s'élargissent (3') également en forme d'entonnoir depuis ces courbures et dans le sens opposé au sens d'enfichage.

8. Bâti selon les revendications 1 à 7, caractérisé par le fait que les bâtis (1) présentent une section transversale longue et que les étriers de retenue (3) sont fixés par leurs extrémités dans les trous (12, 13) pratiqués dans les longues faces latérales (1") du bâti et qu'ils se servent de leur zone intermédiaire de serrage et de support (14) pour sortir en saillie dans la zone (8) entre les bâtis afin qu'ils puissent saisir les bords (6) des plaquettes touchants les courtes faces latérales (1') des bâtis.

9. Bâti selon la revendication 8, caractérisé par le fait que les courbures (9) se trouvent dans la zone de serrage et de support (14).

10. Bâti selon les revendications 1 à 9, caractérisé par le fait que des étriers en saillie (17) munis d'éléments de blocage supplémentaires (15) sont fixés aux bâtis (1) transversalement au sens de la longueur (16), éléments qui se situent sur les bords des plaquettes (6) et qui empêchent ces dernières de se déplacer vers l'intérieur (18), c'est-à-dire dans l'espace (8) situé entre deux bâtis (1) faisant une paire.

11. Bâti selon la revendication 10, caractérisé par le fait que les éléments de blocage supplémentaires ont la forme de douilles coniques (15) dont l'agencement sur boulons (17) leur permet d'effectuer des rotations et des déplacements, les boulons (17) convergeant vers l'intérieur (18).

Fig. 1

Fig . 3

Fig . 2

Fig . 4

Fig . 5

Fig. 6

Fig. 7